## Europäisches Patentamt
## European Patent Office
## Office européen des brevets

(19)

(11) Numéro de publication: **0 001 374**
**B1**

(12) **FASCICULE DE BREVET EUROPEEN**

(45) Date de publication du fascicule de brevet: **07.10.81**

(51) Int. Cl.³: **H 01 L 29/72**

(21) Numéro de dépôt: **78430011.3**

(22) Date de dépôt: **25.08.78**

(54) Transistor à films minces semi-conducteurs amorphes et à base métallique.

(30) Priorité: **26.09.77 US 836874**

(43) Date de publication de la demande:
**04.04.79 Bulletin 79/7**

(45) Mention de la délivrance du brevet:
**07.10.81 Bulletin 81/40**

(84) Etats Contractants Désignés:
**BE DE FR GB**

(56) Documents cités:
**DE - A - 1 439 688**

**IBM TECHNICAL DISCLOSURE BULLETIN
Vol. 20, n° 9, février 1978,
New York
M.H. BRODSKY et al: "Light-sensitive thin-film
métal base transistor", pages 3731—3734**

(73) Titulaire: **International Business Machines
Corporation
Armonk, N.Y. 10504 (US)**

(72) Inventeur: **Deneuville, Alain Francis Georges
Croton Falls
Westchester New York 10519 (US)**

(74) Mandataire: **Klein, Daniel
COMPAGNIE IBM FRANCE Département de
Propriété Industrielle
F-06610 La Gaude (FR)**

Transistor à films minces semi-conducteurs amorphes et à base métallique

## Domaine technique

La présente invention concerne les transistors d'amplification et de commutation et, plus particulièrement, les transistors à films minces semi-conducteurs amorphes et à base métallique.

## Etat de la technique antérieure

Un article de A.B. Fowler intitulé "Thin Film Technology Part III—Active Thin film Devices", paru dans la publication "IEEE Spectrum", juin 1964, pages 102 à 106 et 111, décrit le principe des transistors à films minces en matériau polycristallin (CdS, CdSe, GeS ou PbS), et évoque le principe d'un transistor en matériau semi-conducteur cristallin comportant une base métallique.

Le brevet des E.U.A No. 3 748 501 décrit un dispositif de commande à trois bornes, du genre transistor, utilisant un matériau présentant un seuil de conductivité. Ce brevet ne fait aucune allusion à un transistor du type N—P—N dont les caractéristiques varieraient de façon continue, mais cependant met en oeuvre des électrons chauds (ou énergétiques) pour moduler la conductance dans le corps, de certains autres types de matériau amorphe. Une couche servant d'émetteur 24 et composée d'aluminium est déposée par pulvérisation sur un substrat isolant. On procéde ensuite au dépôt par pulvérisation d'un film mince 28 composé d'un matériau isolant, $Al_2O_3$ par exemple, d'une épaisseur variant entre 75 Å et 200 Å environ et qui est transparent aux électrons, puis d'un film mince en Al ou Mo d'une épaisseur variant entre 75 Å et 200 Å environ constituant une base 16. Un film isolant amorphe 12 est enfin déposé par pulvérisation avec une épaisseur variant entre 7500 Å et 20 000 Å environ, ce film présentant une caractéristique de seuil de conductivité. Les matières employées comprennent notamment les compositions suivantes (en poids atomique): (1) 25% d'arsenic et 75% d'un mélange composé de 90% de tellure et de 10% de germanium; (2) 40% de tellure, 35% d'arsenic, 18% de silicium, 6,75% de germanium et 0,25 d'hélium; et (3) 28% de tellure, 34,5% d'arsenic, 15,5% de germanium et 22% de soufre. Un contact ohmique est formé par dépôt d'un matériau tel que l'Al ou le Mo sur le film amorphe. Aucune mention n'est faite dans cet brevet des transistors à films semi-conducteurs amorphes, ni de la combinaison de dispositifs de Schottky montés en inverse dos à dos qui est un des objets de la présente invention. Ce brevet concerne des dispositifs amorphes bistables qui ne permettent pas d'obtenir la gamme étendue de sorties qui peut être obtenue (en fonction du potentiel de l'électrode de base) avec le dispositif à barrière de la présente invention.

L'article de Sze et al intitulé "Hot-Electron Transport in Semiconductor-Metal-Semiconductor Structures" paru dans la publication "Journal of Applied Physics", Vol. 37, No. 7, juin 1966, page 2690, décrit une structure monocristalline comportant une base métallique à film mince déposée sur un substrat en silicium monocristallin et qui se trouve en contact mécanique avec un plot en silicium cristallin servant d'émetteur. De telles structures cristallines sont difficilement utilisables en raison des dimensions relativement importantes de ce plot silicium et de la difficulté que présente l'établissement d'un contact sans que cette opération s'accompagne de la destruction du film métallique mince.

Le brevet des E.U.A. No. 3 872 492 décrit l'emploi du silicium amorphe comme matériau diélectrique, mais non pas en tant que matériau semi-conducteur actif comme c'est le cas dans la présente invention.

Le brevet des E.U.A. No. 4 015 282 décrit un dispositif comportant deux couches d'un matériau semi-conducteur séparées par une couche amorphe. Ce dispositif est basé sur un fonctionnement bistable et aucune allusion n'est faite à un dispositif dont les caractéristiques électriques varient de façon continue.

On peut également citer à titre de référence les brevets des E.U.A. Nos. 3 470 427; 3 877 049; 3 886 577; 3 886 578 (ce dernier décrit le fonctionnement d'un dispositif à films minces) et 3 987 311 (qui décrit l'emploi de semi-conducteurs amorphes dans des circuits logiques à films minces).

Un article de Wronski et al intitulé "Schottky-Barrier Characteristics of Metal-Amorphous Silicon Diodes", paru dans la publication "Applied Physics Letters", Vol. 29, No. 9 1er novembre 1976, pages 602 à 605, décrit le fonctionnement d'une diode de Schottky en silicium amorphe, l'emploi du silicium amorphe déposé par décharge luminescente et la réalisation d'une barrière de Schottky à partir d'un métal tel que le Pd ou le Pt. Toutefois, les enseignements de cet article ne s'appliquent pas à des dispositifs à trois bornes, du type transistor.

L'article précité de Sze et al n'est pas en mesure de prévoir qu'un collecteur (ou un émetteur) pourrait être déposé sous vide sur une base métallique puisqu'il semblerait, à la lumière de l'art antérieur disponible à cette époque, que le dépôt épitaxial d'un film de silicium monocristallin était irréalisable sur une base métallique (cf. Lindmayer, "the Metal-Gate Transistor" paru dans la publication "Proceedings IEEE", Vol. 52, 1964, page 1751).

Un transistor à effet de champ qui n'utilise qu'une seule couche de silicium amorphe est écrit dans l'article de Neudeck et al, paru dans la publication "Solid State Electronics", Vol. 19, août 1976, pages 721 à 729. L'emploi d'un semi-conducteur à films minces dans un transistor à base métallique est lui aussi original. Il est connu du brevet français No. 1 433 160 un transistor à base métallique où cette dernière est disposée entre deux couches semi-conductrices, ces couches pouvant être polycristallines ou monocristallines.

En résumé aucune allusion n'est faite dans l'art antérieur aux avantages que présenteraient le remplacement du silicium monocristallin par du silicium amorphe, permettant d'obtenir un dispositif utilisable.

L'emploi de plusieurs couches d'un semi-conducteur amorphe tel que du silicium amorphe hydrogéné dans un transistor à films minces apparaît présenter également un caractère original.

Exposé de l'invention

Les matériaux employés dans les transistors de la présente invention présentent des caractéristiques dites ci-après de conductance monostable pour les distinguer des matériaux dont les caractéristiques sont dites ici de conductance bistable, ces derniers, notamment les chalcogénures amorphes présentent des états de fonctionnement alternés d'isolement et de conduction. Les matériaux monostables deviennent semi-conducteurs lorsqu'on leur applique une énergie d'activation électrique variant entre 0,2 et 0,8 eV, c'est le cas, dans certaines conditions, du silicium amorphe hydrogène.

La présente invention a pour objet un transistor à films minces qui comprend: un premier film d'un premier matériau semi-conducteur et une première électrode qui lui est connectée par un contact ohmique; une base composée d'un film mince d'un métal lié au premier film semi-conducteur et connectée à une seconde électrode; un film mince d'un second matériau semi-conducteur de type amorphe présentant une caractéristique de conductance monostable et lié à la base; une électrode est connectée à ce dernier film au moyen d'un second contact ohmique.

Le matériau du premier film semi-conducteur peut être un corps semi-conducteur monocristallin, mais sera de préférence un film mince monostable amorphe déposé sur un substrat. Le silicium amorphe hydrogène remplit ces conditions.

Un premier avantage de l'invention réside dans l'obtention d'un transistor à films minces amorphes dont la courbe de réponse varie de façon continue, et peu coûteux.

Un autre avantage de l'invention est de fournir un transistor à films minces amorphes pouvant être réalise au moyen des techniques de fabrication des films minces peu onéreuses telles que les techniques additives (dépôt par décharge luminescente, évaporation, pulvérisation, etc.) et/ou soustractives (décapage par pulvérisation, décapage par ions réactifs ou décapage chimique) avec utilisation de matériaux photo-résistants, de plaquages, etc. Un faible prix de revient est assuré puisque la fabrication de films amorphes satisfaisants n'exige aucune structure cristalline et donc aucune croissance épitaxiale.

Encore un autre avantage de la présente invention est de rendre possible la fabrication de transistors à films minces à une température relativement basse qui est une caractéristique importante des matériaux amorphes tel que le silicium amorphe afin d'éviter qu'un matériau sensible à la chaleur qui pourrait éventuellement recouvrir le substrat ne soit endommagé.

Un autre avantage connu est de fournir un transistor à films minces qui puisse être réalisé sur le même substrat que des dispositifs à bulles magnétiques ou d'affichage à films minces tels que des dispositifs d'affichage électrochromiques, fluorescents, électroluminescents, etc. Ces dispositifs sont souvent réalisés sur des substrats autres que du silicium cristallin. Il est donc souhaitable de pouvoir disposer de transistors susceptibles d'être réalisés sur des substrats non cristallins.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1 représente un transistor à films minces réalisé conformément à la présente invention.

La figure 2 représente le potentiel électrique des électrons du dispositif de la figure 1 en fonction des distances séparant ses différentes couches du substrat.

La figure 3 représente un autre transistor à films minces analogue à celui de la figure 1 et dans lequel les positions du collecteur et de l'émetteur ont été inversées.

La figure 4 représente un transistor à base métallique comportant au moins une région cristalline et une région amorphe, toujours conformément à la présente invention.

Description détaillée des modes de réalisation

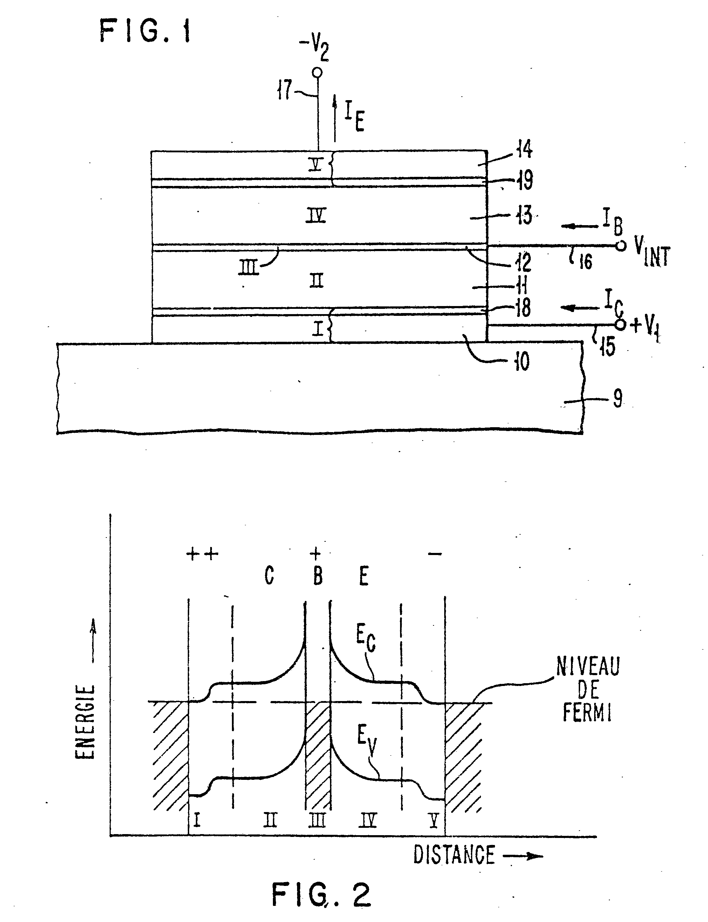

On a représenté sur la figure 1 un dispositif à films minces conforme à la présente invention. Un contact ohmique I 10 à film mince est déposé sur un substrat 9. Le contact ohmique I est en général composé d'une ou plusieurs couches. Par exemple il est composé d'une couche 10 d'un matériau tel que du molybdène recouvert d'une couche 18 de silicium amorphe hydrogéné; ce dernier est dopé au moyen d'une impureté de type N jusqu'à ce qu'il soit dégénéré. Le substrat 9 se compose d'un matériau tel que du silicium cristallin, du verre, d'une matière plastique, du silicium, du quartz fondu, ou d'autres isolants électriques. Le contact I peut avoir une épaisseur de l'ordre de 0,1 micron.

La couche suivante 11 constitue le collecteur du transistor et se compose de préférence d'un matériau amorphe tel que du silicium amorphe hydrogéné présentant une caractéristique de conductance monostable. Ce matériau amorphe peut être déposé sous vide soit:

a) en décomposant du silane ($SiH_4$) dans une décharge luminescente sur un substrat à 250°C environ, ce qui assure le nombre minimum d'états électroniques localisés dans l'intervalle de bande du semi-conducteur (cf. W.E. Spear et al, "Investigation of the Localised State Distribution in Amorphous Si Films", article paru dans publication intitulée "Journal of Non-Crystalline Solids", 8—10 (1972), pages 727 à 738, North Holland Publishing Co.), soit ,

b) par pulvérisation haute fréquence de silicium provenant d'une cible en silicium dans une atmosphère réactive contenant de l'hydrogène sur un substrat à une température d'environ 200°C (cf. l'article de Connel et al intitulé "Use of Hydrogenation in Structural and Electronic Studies of Gap States in Amorphous Germanium", paru dans la publication "Physical Review B", Vol. 13, No. 2, 15 janvier 1976, pages 787 à 804).

Dans un cas ou dans l'autre, un dopage de type N et/ou de type P peut également être employé pour ajuster la hauteur de la barrière. Dans le procédé a), le dopage peut être effectué de la façon préconisée dans l'article de Spear et LeComber intitulé "Substitutional Doping of Amorphous Silicon", paru dans "Solid State Communications", Vol. 17, pages 1192 à 1196 (1975). Dans le cas du procédé b), le dopage peut être réalisé de la façon décrite dans l'article de Paul et al intitulé "Doping Schottky Barrier and p-n Junction Formation in Amorphous Germanium and Silicon by rf Sputtering", paru dans "Solid State Communications" Vol. 20, pages 969 à 972 (1977).

La couche 12 constituant la base est déposée sous vide sur le collecteur 11, sous la forme d'un film très mince d'un métal tel que du platine, du palladium, etc.; ce métal doit présenter un chemin de parcours moyen suffisamment long pour les électrons chauds (de l'ordre de 100 Å ou davantage, voir l'article précité de Sze et al). Ce dépôt peut être effectué notamment par évaporation du métal jusqu'à obtention d'une épaisseur de 100 Å environ ou moins, étant entendu néanmoins qu'une épaisseur minimum de métal est requise pour assurer l'absence de trous d'épingle dans la couche métallique 12. A titre d'exemple, une couche de platine d'une épaisseur de 90 Å disposée entre deux couches de silicium amorphe hydrogéné déposées par décharge luminescente s'est révélée satisfaisante. La base 12 est connectée à l'électrode 16 au moyen des techniques de fabrication classiques bien connues de l'homme de l'art.

L'émetteur 13 est constitué par un film mince en matériau semi-conducteur amorphe présentant une caractéristique de conductance monostable, identique à celle de la couche 11. L'émetteur 13 se compose de préférence d'une couche déposée sous vide de silicium amorphe hydrogéné, par un procédé identique à celui utilisé pour le dépôt de la couche 11 constituant le collecteur.

Un contact ohmique V comporte un film métallique 14 mince, de préférence analoque à la couche 10, et une couche 19 constituée par du silicium amorphe hydrogéné dopé au moyen d'une impureté de type N. La couche 19 est formée par dépôt sur la couche 13 avant le dépôt du film métallique 14, par exemple, en aluminium.

Le dispositif de la figure 1 peut fonctionnner de la même façon qu'un transistor du type silicium cristallin/métal/silicium cristallin. Par exemple, on peut appliquer une tension $-V_2$ à l'émetteur 13 (IV), une tension $V_{INT}$ à la base 12 (III), et une tension $+V_1$ au collecteur 11 (II). Des électrons sont émis par l'émetteur 13 (IV) par dessus la barrière du potentiel de la jonction (IV—III). Certains de ces électrons sont rendus énergétiques dans le métal 12, donnant ainsi un courant continu de base $I_B$. Un faible courant de base est souhaitable. Le métal constituant la couche 12 doit donc présenter le chemin de parcours moyen le plus long possible pour les électrons chauds, et, pour obtenir un résultat optimum, ce métl doit avoir l'épaisseur minimum qui peut être atteinte sans qu'il y ait pour autant formation de trous d'épingle. La jonction (III—II) est polarisée en inverse et recueille les électrons chauds qui subsistent après franchissement de la base 12, donnant ainsi un courant qui s'ajoute au courant inverse de la jonction collecteur-base. Le courant de collecteur $I_C$ est égal à $I_E - I_B$. Une amplification est obtenue de la même façon que dans un transistor classique en appliquant une tension alternative (ou en courant alternatif) entre l'électrode 16 de la base et l'électrode 17 de l'émetteur, et en recueillant le courant alternatif résultant sur l'électrode 15 du collecteur.

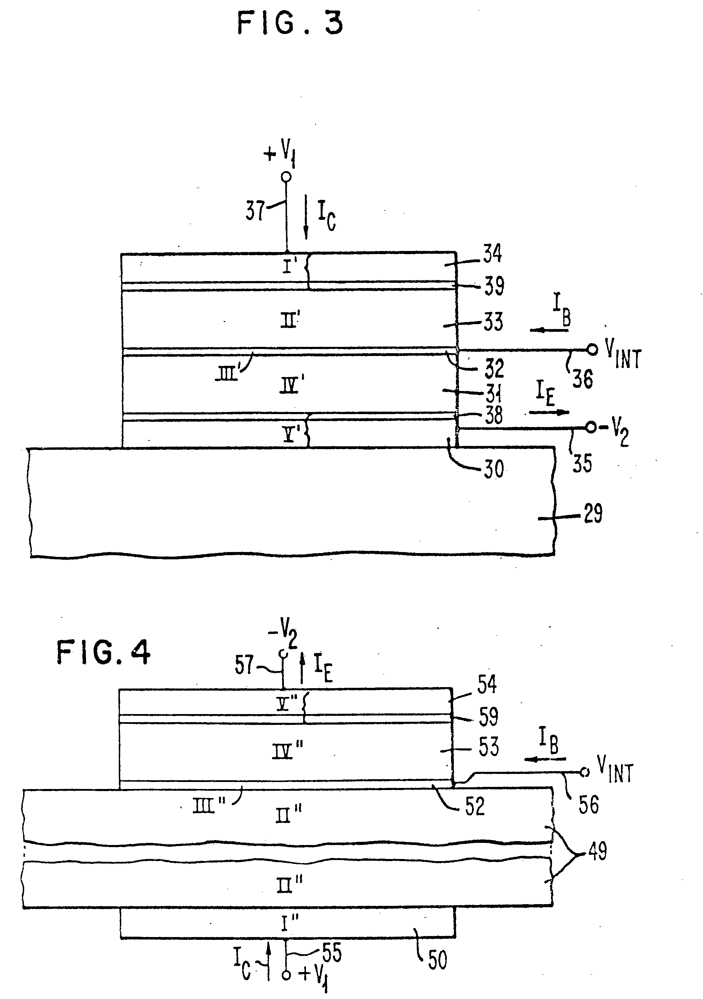

La figure 3 représente une variante de la réalisation de la figure 1 dans laquelle les positions du collecteur et de l'émetteur ont été inversées. Un contact ohmique V' à film mince est réalisé sur un substrat 29. Le substrat 29 se compose d'un matériau tel que fer, une matière plastique, du silicium, du quartz fondu ou d'un quelconque isolant électrique. Le contact ohmique V' se compose de préférence d'une couche 30 d'un matériau tel que molybdène, recouverte d'une couche 38 en silicium amorphe hydrogéné, dopé au moyen d'une impureté de type N jusqu'à ce qu'il soit dégénéré. Le contact V' peut avoir une épaisseur de l'ordre de 0,1 micron.

La couche suivante 31 constitue l'émetteur du transistor et se compose de préférence d'un matériau amorphe tel que du silicium amorphe hydrogéné présentant une caractéristique de conductance monostable, ce matériau pouvant être déposé sous vide de la même façon que le collecteur 11 du dispositif de la figure 1.

La couche 32 constituant la base est déposée sur l'émetteur 31 sous la forme d'un film très mince d'un métal tel que du platine ou du palladium, de la même façon que la couche 12 de la figure 1. Une électrode 36 connecte la couche 32 à une source de tension de polarisation, $V_{INT}$. Ce qui a été dit plus haut au sujet de la couche 12 s'applique également à la couche 32.

La couche 33 constituant le collecteur est un film semi-conducteur mince analogue à la couche 31. Le collecteur 33 se compose de préférence d'une autre couche, déposée sous vide, d'un film amorphe tel que du silicium amorphe hydrogéné présentant une caractéristique de conductance monostable et réalisé de la même façon que la couche 31.

Un contact ohmique I' à film métallique mince est de préférence analogue au contact V', une couche 39 en silicium amorphe hydrogéné dopé au moyen d'une impureté de type N étant déposée sur la couche 33 avant le film métallique 34, constitué, par exemple, par de l'aluminium.

Le dispositif représenté sur la figure 3 peut fonctionner de la même façon qu'un transistor du type silicium cristallin/métal/silicium cristallin. Par exemple, on peut appliquer une tension $-V_2$ à l'émetteur 31 (IV'), une tension $V_{INT}$ à la base 32 (III') et une tension $+V_1$ au collecteur 33 (II'). Des électrons sont émis par l'émetteur 31 (IV') par dessus la barrière de potentiel de la jonction (IV'—III'). Certains de ces électrons sont rendus énergétiques dans le métal 32, donnant ainsi un courant continu de base $I_B$. Un faible courant de base étant souhaitable, la couche métallique 32 devrait se composer d'un métal présentant le chemin de parcours moyen le plus long possible pour des électrons chauds, mais aussi pour obtenir des résultats optima, ce métal devrait présenter l'épaisseur minimum, cependant suffisante pour que la couche métallique ne présente pas de trous d'épingle. La jonction III'—II' est polarisée en inverse et recueille les électrons chauds qui subsistent après franchissement de la base 32, ce qui donne le courant de collecteur $I_C = I_E - I_B$. L'amplification est obtenue de la même façon que dans un transistor classique en appliquant une tension alternative (ou un courant alternatif) entre l'électrode 36 de la base et l'électrode 35 de l'émetteur et en recueillant le courant alternatif résultant, à l'électrode 37 du collecteur.

Une caractéristique importante de la présente invention réside dans le fait que plusieurs films minces sont utilisés pour créer des diodes montées dos à dos et séparées par un film métallique mince que les électrons peuvent franchir. L'énergie correspondante des électrons en fonction de la distance séparant les différentes couches et le substrat est représentée schématiquement sur la figure 2.

Les différentes régions ne sont pas à l'échelle. Les électrons injectés depuis l'émetteur polarisé en direct sont recueillis par le collecteur polarisé en inverse sous la commande du potentiel appliqué á l'électrode de la base. Les différentes régions I à V du schéma de la figure 2 correspondant aux couches portant les mêmes références sur la figure 1 et aux couches I' à V' respectivement de la figure 3.

Le schéma de la figure 2, appelé diagramme des bandes d'énergie, a été tracé de façon conventionnelle (voir, par exemple, l'ouvrage de S.M. Sze, intitulé "Physics of Semiconductor Devices", édité par J. Wiley & Sons, Inc., N. Y. 1969, chapitre 8 et chapitre 3, pages 17 à 24). Les régions I et V sont les contacts ohmiques dont chacun est constitué par une couche métallique et par une couche d'un semi-conducteur fortement dopé comme on l'a vu. Les régions II et IV sont les couches semi-conductrices non dopées ou légèrement dopées, les régions de charge d'espace et les barrières créées par leur contact avec la région métallique III constituant la base. L'application à cette dernière d'une polarisation positive par rapport à l'émetteur provoque l'injection d'électrons dans la base III depuis l'émetteur IV. Certains des électrons ainsi éjectés parviendront à l'interface collecteur-base en présentant une énergie suffisamment élevée pour qu'ils puissent franchir la barrière et pénétrer dans le collecteur sous l'influence de champs électriques existant à proximité de cette interface. Le contrôle du courant électronique dans le collecteur est assuré par la polarisation base-émetteur et/ou par la polarisation base-collecteur. La courbe supérieure $E_C$ représente la limite inférieure de la bande de conduction en fonction de la distance. La courbe inférieure $E_V$ réprésente la limite supérieure de la bande de valence en fonction de la distance. La bande interdite se trouve entre ces limites. (Voir l'ouvrage de C. Kittel, intitulé "Introduction to Solid State Physics", édité par John Wiley & Sons, Inc. N.Y., 1956, pages 347 à 401). La limite inférieure de la courbe $E_C$, qui atteint son point le plus élevé dans l'émetteur, indique le niveau d'énergie qu'un électron doit avoir atteint pour pouvoir franchir la jonction émetteur-base. Le passage de la base à l'émetteur n'exige aucune énergie supplémentaire.

La figure 4 représente encore un autre transistor en matériau semi-conducteur amorphe dont la base est constituée par un film métallique mince, et dans lequel l'émetteur ou le collecteur, mais non les deux, se compose d'un matériau semi-conducteur cristallin présentant une caractéristique de conductance monostable. Comme le montre la figure, un fragment d'une partie 49 d'une tranche d'un matériau semi-conducteur cristallin, constitué de préférence par du Si, du GaAs ou du Ge, etc., comporte sur sa face arrière une couche 50 formant un contact ohmique et une électrode 55 (connectée à une source de potentiel $+V_1$) permettant d'utiliser cette partie 49 comme collecteur. (De même, à titre de variante la partie 49 peut faire fonction d'émetteur lorsqu'on inverse la tension de polarisation, qui devient alors $-V_2$). Le contact ohmique 50 peut être d'un type classique quelconque bien connu de l'homme de l'art.

La première couche déposée sur la partie 49 est un film mince 52 d'un métal tel que le chrome qui présente un chemin de parcours moyen suffisamment long et qui constitue la base du dispositif, la couche 52 pouvant être déposée par exemple, par évaporation jusqu'à obtention d'une épaisseur d'environ 100 Å ou moins, de même que dans le cas de la base 12 du dispositif de la figure 1. La base 52 est reliée par une électrode 56 à une source de tension $V_{INT}$.

Une couche 53 constituant l'émetteur (ou le collecteur dans le cas de la variante décrite précédemment) est un film mince d'un matériau semi-conducteur amorphe présentant une caractéristique de conductance monostable et relié à la base 52. De préférence, la couche 53 se compose d'un film amorphe d'un matériau tel que du silicium amorphe hydrogéné, déposé sous vide de la même façon que le collecteur 11 du dispositif de la figure 1.

Un contact ohmique V″ à film métallique mince est de préférence analogue au contact I du dispositif de la figure 1, une couche 59 de silicium amorphe hydrogéné dopé au moyen d'une impureté de type N étant déposée sur la couche 53 avant le film métallique 54 composé, par exemple, d'aluminium. Le contact ohmique V″ est connecté au moyen d'une électrode 57 à une tension $-V_2$ ($+V_1$ dans le cas de la variante précitée). Le fonctionnement de ce dispositif est analogue à celui du dispositif de la figure 1 (figure 3), précédemment décrit.

Les dispositifs à trois bornes des figures 1, 3 et 4 peuvent être utilisés de la même façon que des transistors cristallins classiques dans des circuits électroniques, dans des applications en courant continu ou en courant alternatif, ou dans des applications nécessitant une adaptation d'impédance. (Voire le livre précité de S.M. Sze). Par exemple, les trois agencements habituels, base commune avec application d'une polarisation continue entre l'émetteur et la base (V et III, V′ et III′, V″ et III″) sur les figures 1, 3 et 4, où entre la base et le collecteur (III et I, III′ et I′, III″ et I″) sur les figures 1, 3 et 4; émetteur commun avec application d'une polarisation continue entre l'émetteur et la base (V et III, V′ et III′, V″ et III″) sur les figures 1, 3 et 4; et entre l'émetteur et le collecteur (V et I, V′ et I′, V″ et I″) sur les figures 1, 3 et 4.

Les matériaux semi-conducteurs de la présente invention présentent une caractéristique de conductance monostable, ce qui les différencie des matériaux présentant une caractéristique dite, dans la présente description, de "conductance bistable", tels que les verres de chalcogénures, y compris les alliages d'As, de Te et de Ge qui ont des états de conductance bistable.

Le tableau I ci-dessous présente les données obtenues relativement à un dispositif du type de celui décrit sur la figure 1. Ce dispositif avait été déposé sur un substrat en silicium cristallin. Une mince couche en molybdène d'une épaisseur d'environ 1500 Å avait été déposé par évaporation sur ce substrat. Une couche de silicium amorphe hydrogéné dopé au moyen d'une impureté de type N avait ensuite été déposée sur la couche de molybdène à partir d'une mélange de silane et de phosphine dans une décharge luminescente. L'ensemble des deux couches constituant le contact ohmique. Une couche d'environ 6000 Å d'épaisseur de silicium amorphe hydrogé intrinsèque constituant le collecteur avait ensuite été déposée sur la couche dopée au moyen d'une impureté de type N à partir de silane pur dans une décharge luminescente. Un film mince de platine d'une épaisseur d'environ 90 Å et constituant la base avait ensuite été déposé par évaporation sur le collecteur. Une couche de silicium amorphe hydrogéné d'un épaisseur d'environ 6000 Å et constituant l'émetteur avait ensuite été déposée sur la base de la façon indiquée ci-dessus. Un film amorphe hydrogéné dopé au moyen d'une impureté du type N et d'une épaisseur de 200 Å avait ultérieurement été appliqué de la façon indiquée plus haut, cette application étant suivie du dépôt par évaporation d'une couche en aluminium d'une épaisseur d'environ 2000 Å, pour constituer le contact ohmique d'émetteur.

L'épaisseur des couches formant contact doit être suffisamment grande pour que le courant puisse traverser le dispositif, ainsi que le comprendra l'homme de l'art.

TABLEAU I

| Emetteur (en haut) | | Collecteur (en bas) | | Paramètres d'injection | |
|---|---|---|---|---|---|
| $V_{BE}$ (volts) $= V_{INT} - (-V_2)$ | $I_E$ (A) | $V_{BC}$ (volts) $V_1 - V_{INT}$ | $I_C$ (A) | $\Delta I_C$ (A) | $\dfrac{\Delta I_C}{I_E}$ |
| 0 | 0 | 0 | 0 | 0 | |
| 0,2 | $1,2 \times 10^{-9}$ | 0 | 0 | $6 \times 10^{-12}$ | $5 \times 10^{-3}$ |
| 0,5 | $1,2 \times 10^{-8}$ | 0 | 0 | $1,4 \times 10^{-11}$ | $1,16 \times 10^{-3}$ |
| 0,5 | $1,2 \times 10^{-8}$ | 1,0 | $1,7 \times 10^{-10}$ | $3 \times 10^{-11}$ | $2,5 \times 10^{-3}$ |
| 0,5 | $1,2 \times 10^{-8}$ | 2,5 | $7,5 \times 10^{-9}$ | $1 \times 10^{-9}$ | $8 \times 10^{-2}$ |
| Polarisé en direct | | Polarisé en inverse | | | |

0 001 374

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Transistor à films minces semi-conducteurs et à base métallique du genre comprenant: un premier film mince (11) d'un premier matériau semi-conducteur, un second film mince (13) d'un second matériau semi-conducteur, un film mince métallique (12) disposé entre lesdits premier et second films et qui constitue la région de base dudit transistor, des moyens de polarisation (15, 16, 17) dudit transistor, caractérisé en ce que, ledit second matériau semi-conducteur est de type amorphe monostable.

2. Transistor selon la revendication 1 caractérisé en ce que ledit premier matériau semi-conducteur est monocristallin ou amorphe monostable.

3. Transistor selon la revendication 2 caractérisé en ce que ledit matériau amorphe monostable est du silicium amorphe hydrogéné.

4. Transistor selon la revendication 1, 2 ou 3 caractérisé en ce que les moyens de polarisation comprennent d'une part un premier contact ohmique (I) avec le premier film mince (11) relié à une première électrode (15), une deuxième électrode (16) reliée au film mince métallique (12) formant la base et un second contact ohmique (V) avec le second film mince (13) relié à une troisième électrode (17), et d'autre part des sources de potentiel appropriées ($V_1$, $V_2$, $V_{INT}$) connectées à chacune des trois électrodes.

5. Transistor selon la revendication 4 caractérisé en ce que, le premier contact ohmique (I) est constitué par une couche métallique (10) et une couche de silicium amorphe hydrogéné fortement dopée (18).

6. Transistor selon la revendication 5 caractérisé en ce que le film mince métallique (12) est en molybdène ou en platine.

7. Transistor selon la revendication 5 ou 6 caractérisé en ce que le second contact ohmique (V) est également constitué par une couche métallique (14) et une couche de silicium amorphe hydrogéné fortement dopée (13).

## Patentansprüche

1. Dünnfilm-Metallbasistransistor mit einem ersten dünnen Film (11) eines ersten Halbleitermaterials, einem zweiten dünnen Film (13) eines zweiten Halbleitermaterials, einem dünnen, zwischen dem ersten und zweiten Film angeordneten Metallfilm, der den Basisbereich des Transistors bildet, und Polarisiermittel (15, 16, 17) des Transistors, dadurch gekennzeichnet, dass das zweite Halbleitermaterial vom amorphen, monostabilen Typ ist.

2. Transistor nach Anspruch 1, dadurch gekennzeichnet, dass das erste Halbleitermaterial vom einkristallinen oder amorphen, monostabilen Typ ist.

3. Transistor anch Anspruch 2, dadurch gekennzeichnet, dass das amorphe monostabile Material aus amorphem, hydriertem Silizium besteht.

4. Transistor nach Anspruch 1, 2 oder 3, dadurch gekennzeichnet dass die Polarisiermittel einerseits einen ersten ohmschen Kontakt (I) enthalten, bei dem der erste dünne Film (11) mit einer ersten Elektrode (15), eine zweite Elektrode (16) mit dem dünnen, die Basis bildenden Metallfilm (12) verbunden ist, und eine zweiter ohmscher Kontakt V, bei dem der zweite dünne Film (13) mit einer dritten Elektrode verbunden ist, und andererseits geeigenete Potentialquellen ($V_1$, $V_2$, $V_{INT}$), die an jede der drei Elektroden angeschlossen sind.

5. Transistor nach Anspruch 4, dadurch gekennzeichnet, dass der erste ohmsche Kontakt (I) aus einer ersten Metallschicht (10) und aus einer hochdotierten, hydrierten, amorphen Siliziumschicht (18) gebildet wird.

6. Transistor nach Anspruch 5, dadurch gekennzeichnet, dass der dünne Metallfilm aus Molybdän oder platin besteht.

7. Transistor nach Anspruch 5 oder 6, dadurch gekennzeichnet; dass der zweite ohmsche Kontakt (V) ebenfalls aus einer Metallschicht (14) und einer hochdotierten, hydrierten, amorphen Siliziumschicht (19) gebildet wird.

## Claims

1. Thin film metal base transistor of the type including: a first thin film (11) of a first semiconductor material, a second thin film (13) of a second semiconductor material, a thin metal film (12) between the first and the second film that forms the base region of said transistor, and biasing means (15, 16, 17) of said transistor, characterized in that said second semiconductor material is of the amorphous, monostable type.

2. Transistor according to claim 1, characterized in that said first semiconductor material is of the monocrystalline or amorphous monostable type.

3. Transistor according to claim 2, characterized in that said amorphous, monostable material consists of hydrogenated, amorphous silicon.

4. Transistor according to claim 1, 2 or 3, characterized in that the biasing means include on the one hand a first contact (I) having the first thin film (11) connected to a first electrode (15) and a second electrode (16) connected to the thin metal film (12) forming the base, and a second contact (V) having the second thin film (13) connected to a third electrode (17), and on the other hand appropriate potential sources ($V_1$, $V_2$, $V_{INT}$) that are connected to the three electrodes.

5. Transistor according to claim 4, characterized in that the first ohmic contact (I) consists of a metal layer (10) and of a heavily doped hydrogenated, amorphous silicon layer (18).

6. Transistor according to claim 5, characterized in that the thin metal film consists of molybdenum or platinum.

7. Transistor according to claim 5 or 6, characterized in that the second ohmic contact (V) also consists of a metal layer (14) and a heavily doped, hydrogenated, amorphous silicon layer (19).

# FIG. 1

# FIG. 2

# FIG. 3

# FIG. 4